# EUROPEAN PATENT APPLICATION

(11) **EP 4 056 731 A1**
(43) Date of publication of application: **14.09.2022**
(21) Application number: 20885070.1
(22) Date of filing: 02.11.2020
(51) Int. Cl.: C23C 16/455, C23C 16/40, H01L 21/31, H01L 21/316

(54) **FILM FORMATION METHOD AND FILM FORMATION DEVICE**

(30) Priority: 06.11.2019 JP 2019201441
(71) Applicant: Creative Coatings Co., Ltd., Shinjuku-ku Tokyo 162-0842 (JP)
(72) Inventor: SATO, Eiji, Tokyo 162-0842 (JP); SAKAMOTO, Hitoshi, Tokyo 162-0842 (JP)
(74) Representative: Wunderlich & Heim Patentanwälte Partnerschaftsgesellschaft mbB
(86) International application number: PCT/JP2020/041016
(87) International publication number: WO 2021/090794

(57) **Abstract**

A film formation method for forming a CVD film (4) and an ALD film (5) on a film formation target. In an ALD process for forming the ALD film, an ALD cycle is repeatedly executed a plurality of times, the ALD cycle including: a first step for filling a reaction container (20) in which the film formation target is disposed, with a source gas introduced through a first supply pipe (100); a second step for exhausting the source gas from the reaction container after the first step; a third step for filling the reaction container with a reactant gas activated by an inductively coupled plasma in a second supply pipe (200) and introduced through the second supply pipe (200) after the second step; and a fourth step for exhausting the reactant gas from the reaction container after the third step. In a CVD process for forming the CVD film, the ALD cycle is executed at least once, and the second step is finished while leaving the source gas in a gas phase in the reaction container.

## Description

### TECHNICAL FIELD

The present invention relates to a film formation method and a film formation device capable of continuously forming a chemical vapor deposition (CVD) film and an atomic layer deposition (ALD) film in the same reaction container.

### BACKGROUND ART

Patent Document 1 describes a method for forming an ALD film after forming a CVD film in the same reaction container.

### RELATED-ART DOCUMENT

### PATENT DOCUMENT

Patent Document 1: JP-A-2018-59173

### SUMMARY OF THE INVENTION

### TECHNICAL PROBLEM

In Patent Document 1, a source gas and a reactant gas that are used for the formation of both the CVD film and the ALD film are introduced into the reaction container through a shower head disposed on the upstream side of the reaction container. A placement table which is disposed in the reaction container, and on which a film formation target is placed, functions as a lower electrode, an upper structure of the container including the shower head functions as an upper electrode, and plasma is generated in the reaction container.

In an ALD process for forming the ALD film, the source gas required in an adsorption stage, and the reactant gas required in a reaction stage are alternately supplied into the reaction container while exhausting gas (including purging) between the adsorption stage and the reaction stage to separate the adsorption stage and the reaction stage. On the other hand, in a CVD process for forming the CVD film, the source gas and the reactant gas are simultaneously supplied through the shower head, and the pressure is set at, for example, about several 100 Pa at which a plasma is easily generated in the reaction container. In the CVD process, therefore, a reaction occurs in a gas phase, and the relatively high gas partial pressure causes generation of particles and by-products. Additionally, in Patent Document 1, the process is carried out at a high temperature of 350°C to 550°C.

It is the purpose of the invention to provide a film formation method and a film formation device that make it possible to simplify control of both the CVD process and the ALD process by commonizing the processes, enable a low temperature process, and suppress the generation of particles and by-products.

### SOLUTION TO PROBLEM

One aspect of the invention relates to a film formation method for forming a CVD film and an ALD film on a film formation target, the film formation method including an ALD process for forming the ALD film, and a CVD process for forming the CVD film, wherein,
in the ALD process, an ALD cycle is repeatedly executed a plurality of times, the ALD cycle including:
a first step for filling a reaction container in which the film formation target is disposed, with a source gas introduced through a first supply pipe;
a second step for exhausting the source gas in a gas phase in the reaction container after the first step;
a third step for filling the reaction container with a reactant gas activated by an inductively coupled plasma in a second supply pipe and introduced through the second supply pipe after the second step; and
a fourth step for exhausting the reactant gas from the reaction container after the third step, and,
in the CVD process, the ALD cycle is executed at least once, and exhaustion in the second step is finished while leaving the source gas in the gas phase in the reaction container.

According to one aspect of the invention, since the ALD cycle is executed at least once in the CVD process, the CVD process and the ALD process are commonized. Consequently, control of both the processes can be simplified. The CVD process is different from the ALD process at least in that exhaustion in the second step is finished while leaving the source gas in the gas phase in the reaction container. Therefore, if the difference in the exhaust time of the second step is the only difference between the two processes in addition to the number of times of executing the ALD cycle, the control of both the processes can be extremely simplified. When the exhaustion in the second step of the CVD process is finished while leaving the source gas in the gas phase in the reaction container, the reactant gas introduced in the third step reacts with the source gas in the gas phase, and can form a CVD film. Moreover, radicals contained in the activated reactant gas allow saturated adsorption of the reactant gas on the film formation target even at room temperature, and therefore it is not necessary to forcibly heat the film formation target during film formation. Additionally, since the pressure of the source gas is reduced due to the exhaustion in the second step, unlike a reaction at a high pressure as in Patent Document 1, particles and by-products are less likely to be generated.

In one aspect of the invention, the time of the first step may be substantially equally set in the ALD process and the CVD process, and the time of the second step in the CVD process may be set shorter than the time of the second step in the ALD process. By setting the exhaust time of the second step in the CVD process shorter than that in the ALD process while equally setting the source gas introduction time in the ALD process and the CVD process, the exhaustion in the second step of the CVD process can be finished while leaving the source gas in the gas phase in the reaction container.

According to one aspect of the invention, the source gas may be an organometallic gas, and the reactant gas may be an oxidation gas. OH radicals contained in the activated reactant gas enable a low temperature process.

According to one aspect of the invention, the source gas may be an organometallic gas, and the reactant gas may be a nitriding gas. NH radicals contained in the activated reactant gas enable a low temperature process.

According to one aspect of the invention, the film formation target may be a porous material, and have a hole that opens at a surface on which a film is to be formed. In this case, after closing the hole with the CVD process, it is possible to form a dense ALD film on the CVD film.

Another aspect of the invention is a film formation device including:
a reaction container in which a film formation target is disposed;
a first supply pipe that supplies a source gas to the reaction container;
a second supply pipe that is connected to the reaction container, and supplied with a reactant gas;
a reactant gas activation device that activates the reactant gas in the second supply pipe by an inductively coupled plasma;
an exhaust part that exhausts gas in the reaction container; and
a controller that controls a CVD process and an ALD process, wherein
the controller, in the ALD process, controls an ALD cycle to be repeatedly executed a plurality of times, the ALD cycle including:
   a first step for introducing the source gas through the first supply pipe into the reaction container in which the film formation target is disposed;
   a second step for exhausting the source gas from the reaction container through the exhaust part after the first step;
   a third step for introducing the reactant gas activated in the second supply pipe by the reactant gas activation device into the reaction container through the second supply pipe after the second step; and
   a fourth step for exhausting the reactant gas from the reaction container after the third step, and,
   in the CVD process, controls the ALD cycle to be executed at least once, and the second step to be finished while leaving the source gas in a gas phase in the reaction container.

According to another aspect of the invention, it is possible to adequately implement the film formation method that is one aspect of the invention.

### BRIEF DESCRIPTION OF THE DRAWINGS

FIG. 1 is a schematic explanatory view of a film formation device according to one embodiment of the invention.
FIG. 2 is a view illustrating one example of a reactant gas activation device illustrated in FIG. 1.
FIG. 3 is a view illustrating a CVD film and an ALD film formed on a surface of a porous material that is a film formation target.
FIG. 4 is a timing chart of film formation steps for continuously performing a CVD process and an ALD process.
FIG. 5 is a timing chart illustrating the relationship between the CVD process and the ALD process.

### DESCRIPTION OF EMBODIMENTS

Hereinafter, the present embodiment will be described. Note that the embodiment described below does not intend to unduly limit the contents described in the claims. Moreover, not all configurations described in the embodiment are mandatory configuration requirements.

### 1. Film Formation Device

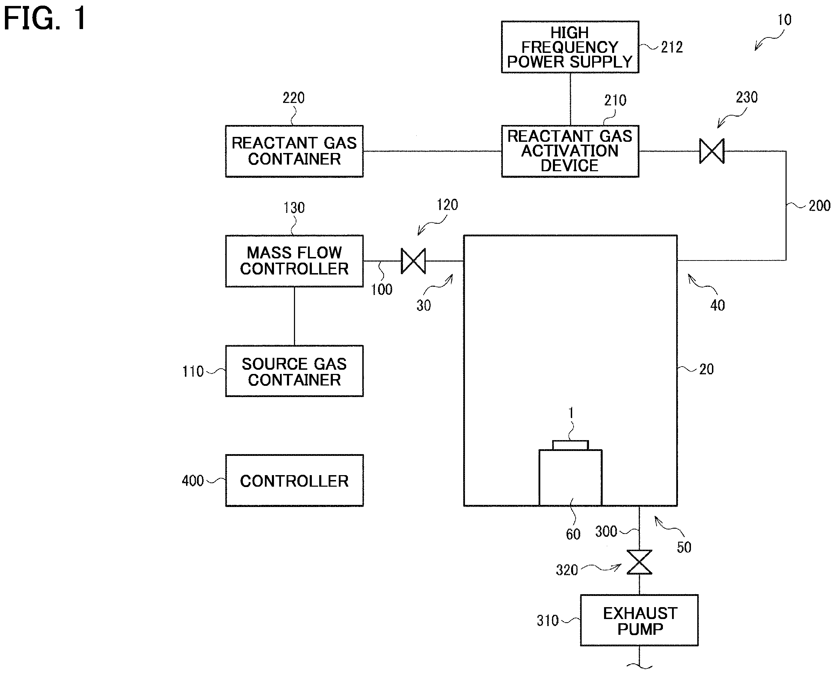

FIG. 1 illustrates a film formation device according to the embodiment. In FIG. 1, a film formation device 10 has a reaction container 20 made of, for example, quartz. The reaction container 20 has a source gas introduction port 30, a reactant gas introduction port 40, and an exhaust port 50. For example, a support 60 for placing and supporting a film formation target 1 thereon is disposed in the reaction container 20.

A first supply pipe 100 is joined to the source gas introduction port 30, and a source gas container 110 and a mass flow controller 130 are connected to the first supply pipe 100. When a first valve 120 attached to the first supply pipe 100 is in an open state, a source gas whose flow rate is controlled by the mass flow controller 130 is supplied from the source gas container 110 to the source gas introduction port 30. A second supply pipe 200 is joined to the reactant gas introduction port 40. A reactant gas activation device 210 is attached to the second supply pipe 200. The reactant gas container 220 supplies a reactant gas to the reactant gas activation device 210. The reactant gas activated by the reactant gas activation device 210 is supplied to the reactant gas introduction port 40 through a second valve 230.

In the embodiment, the source gas is, for example, TDMAS (SiH[N(CH₃)₂], the activated reactant gas is OH radials (OH^{∗}), and a silicon oxide film SiO₂ is formed on the film formation target 1. This is not a limitation, and, for example, trimethylaluminum Al(CH₃)₃ that is used as the source gas may react with OH radials (OH^{∗}), and form a film of aluminum oxide Al₂O₃.

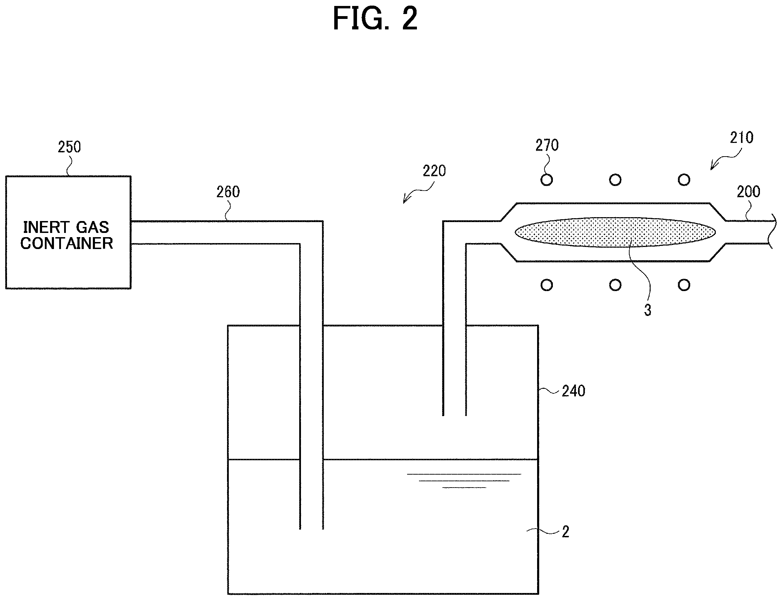

FIG. 2 illustrates one example of the reactant gas container 220, and the reactant gas activation device 210. In FIG. 2, the reactant gas is, for example, water vapor H₂O, and OH radicals (OH^{∗}) are generated by activating the water vapor. Therefore, the reactant gas container 220 includes a humidifier 240 storing water 2, and an inert gas container 250. An inert gas, for example, argon Ar from the inert gas container 250 is introduced to the humidifier 240 through a pipe 260. The water 2 bubbled by the argon Ar becomes a water vapor gas, and is supplied to the second supply pipe 200. An induction coil 270 is mounted around the second supply pipe 200 made of, for example, quartz. A high frequency power supply 212 illustrated in FIG. 1 is connected to the induction coil 270. For example, electromagnetic energy applied by the induction coil 270 is 20 W, and has a frequency of 13.56 MHz. An inductively coupled plasma 3 of the reactant gas is generated in the second supply pipe 200 by the induction coil 270. By supplying the OH radicals (OH^{∗}) to the reaction container 20, it is possible to form a film at a low temperature, for example, room temperature, without forcibly heating the film formation target 1, as described later.

An exhaust pipe 300 is joined to the exhaust port 50 of the reaction container 20, and an exhaust pump 310 and an exhaust valve 320 are attached to the exhaust pipe 300. It is possible to draw a vacuum in the reaction container 20 by the exhaust pump 310. Thus, the source gas or the reactant gas can be exhausted from the reaction container 20. Note that, although not illustrated in the drawings, it is possible to supply the inert gas as a purge gas to the reaction container 20 while controlling the flow rate during the exhaustion by the exhaust pump 310. In order to exhaust the source gas or the reactant gas from the reaction container 20, a purge gas may be introduced to replace the gas in the reaction container 20 with the purge gas. In addition, an inert gas may be used as a carrier gas of the source gas.

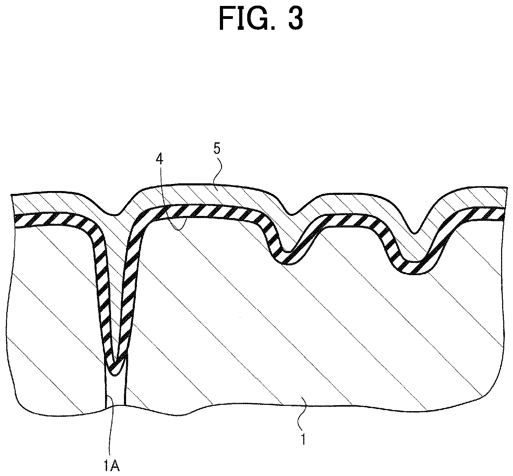

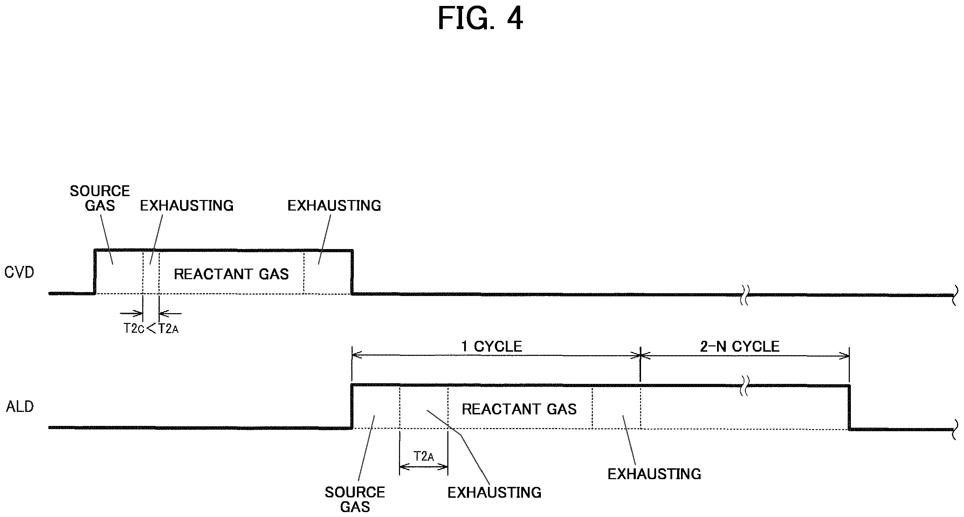

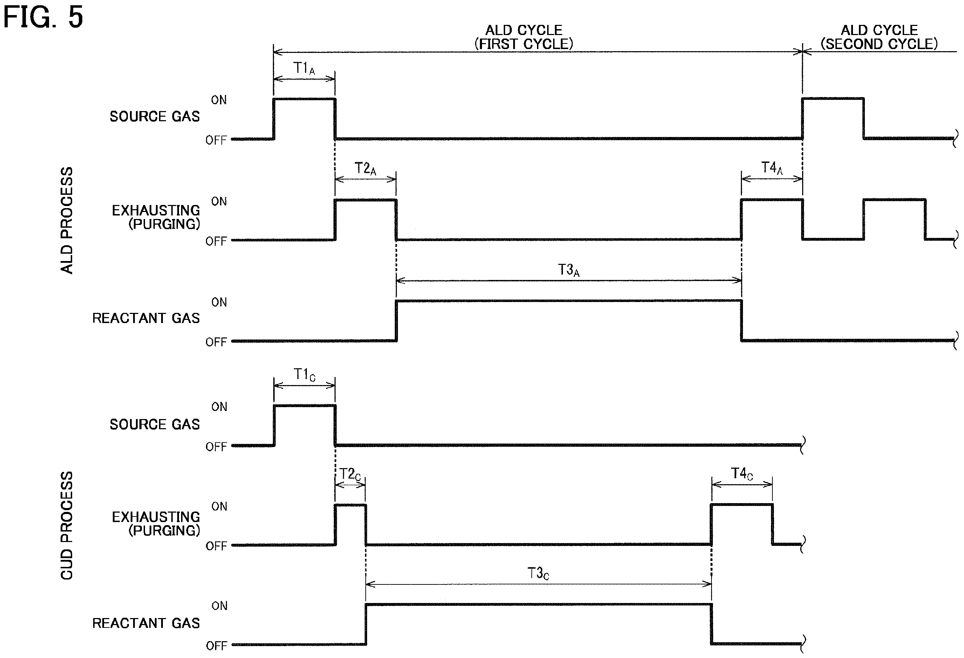

A controller 400 controls a CVD process and an ALD process. FIG. 3 is a schematic view illustrating one example of films formed on a surface of a porous material 1 that is a film formation target by a film formation method executed by the controller 400. FIG. 4 is a timing chart of the film formation method executed by the controller 400, wherein the CVD process and the ALD process are continuously executed. FIG. 5 is a timing chart illustrating the relationship between the CVD process and the ALD process executed by the controller 400. The contents of control by the controller 400 will be described by presenting the film formation method of the embodiment as an example.

### 2. Film Formation Method

As illustrated in FIG. 3, in order to form films on the porous material 1, first, a CVD film 4 is formed, and then an ALD film 5 is formed on the CVD film 4. A hole 1A of the porous material 1 is filled with the CVD film 4, and the dense ALD film 5 can coat the CVD film 4 having a sparse density, and, for example, a poor barrier property. Thus, it is possible to reform the surface of the porous material 1 into the surface having, for example, hydrophobic or hydrophilic properties.

Therefore, in the embodiment, as illustrated in FIG. 4, the controller 400 controls the respective parts of a film formation device 10 so as to first execute the CVD process, and then subsequently execute the ALD process. Moreover, the controller 400 simplifies the control by commonizing the CVD process and the ALD process. Commonizing the CVD process and the ALD process means employing the CVD process that is the same as a single cycle of ALD cycle which is repeatedly executed a plurality of times in the ALD process. Commonizing the CVD process and the ALD process will be explained with reference to FIG. 5.

### 2.1. ALD Process

For the sake of convenience of explanation, first, the ALD process will be explained. In the ALD process, the ALD cycle composed of first to fourth steps as one cycle is repeatedly executed until a film thickness of the ALD film 5 is obtained.

### 2. 1. 1. First Step of ALD Cycle

For executing the ALD cycle, first, a vacuum is drawn in the reaction container 20 by the exhaust pump 310, and the pressure in the reaction container 20 is set, for example, to 10⁻⁴ Pa. Next, as the first step of the ALD cycle, the first valve 120 is brought into the open state, a source gas TDMAS is supplied into the reaction container 20, and then the first valve 120 is closed. Consequently, the inside of the reaction container 20 is filled with the source gas at a relatively low pressure of, for example, 1 to 10 Pa. In the first step of the ALD cycle, TDMAS is adsorbed on the surface of the film formation target 1 on the support 60.

### 2. 1. 2. Second Step of ALD Cycle

After elapse of a T1_{A} time from the start of the first step, as the second step of the ALD cycle, for example, a purge gas is introduced into the reaction container 20, and the source gas TDMAS in the gas phase in the reaction container 20 is exhausted, and thus the gas in the reaction container 20 is replaced with the purge gas. The exhaust time is denoted by T2_{A}.

### 2. 1. 3. Third Step of ALD Cycle

Next, as the third step of the ALD cycle, OH radicals (OH^{∗}) as the reactant gas activated in the reactant gas activation device 210 are introduced into the reaction container 20 by bringing the second valve 230 into the open state. Thereafter, the second valve 230 is closed, and the inside of the reaction container 20 is filled with the reactant gas at a relatively low pressure. As a result, on the surface of the film formation target 1, TDMAS reacts with the OH radicals (OH^{∗}). Specifically, TDMAS is oxidized by the OH radicals (OH^{∗}), and a silicon oxide film SiO₂ is produced. Consequently, the surface of the film formation target 1 is coated with the silicon oxide film. Moreover, a hydroxy group (-OH) is formed on the silicon oxide film. An organometallic gas can be saturated and adsorbed on the hydroxy group (-OH) even at room temperature. Therefore, it is not necessary to forcibly heat the film formation target 1 during film formation.

### 2. 1. 4. Fourth Step of ALD Cycle

After elapse of a T3_{A} time from the start of the third step, as the fourth step of the ALD cycle, for example, a purge gas is introduced into the reaction container 20, and the activated reactant gas in the gas phase in the reaction container 20 is exhausted, and thus the gas in the reaction container 20 is replaced with the purge gas. An exhaust time T4_{A} of the fourth step can be, for example, equal to the exhaust time T2_{A} of the second step.

The ALD cycle composed of the first to fourth steps is repeatedly executed until a film thickness of the ALD film 5 is obtained. In the ALD cycle, at the atomic layer level, for example, 1 angstrom = 0.1 nm is deposited at a time, and, therefore, for example, for a film thickness of 10 nm, the ALD cycle is repeated 100 times. As a modification of the ALD cycle, before introducing the source gas TDMAS into the reaction container 20, the inside of the reaction container 20 is filled with ozone at a pressure of, for example, 1 to 10 Pa, and then the ozone is exhausted by the purge gas. By introducing ozone, it is possible to prevent unreacted carbon from being mixed into the film.

### 2. 2. CVD Process

As illustrated in FIG. 5, the CVD process has first to fourth steps like the ALD cycle. If the time of the first step is T1_{c}, the time of the second step is T2_{c}, the time of the third step is T3_{c}, and the time of the fourth step is T4_{c}, then the times are set to satisfy, for example, T1_{c} = T2_{A}, T2_{c} < T2_{A}, T3_{c} = T3_{A}, and T4_{c} = T4_{A}. In short, in the CVD process, the times are set in the same manner as in the ALD cycle, except that the time T2_{c} of the second step is set to be shorter than the time T2_{A} of the second step of the ALD cycle.

In the CVD process, since the time T2_{c} of the second step is shorter, the source gas TDMAS in the gas phase in the reaction container 20 is not completely exhausted, and partly remains in the gas phase in the reaction container 20. When the third step is started in the state in which the source gas TDMAS remains in the gas phase in the reaction container 20, the source gas TDMAS in the gas phase in the reaction container 20 causes a gas-phase chemical reaction with the introduced OH radicals (OH^{∗}). In short, the CVD process by which the silicon oxide SiO₂ produced by the gas-phase chemical reaction is deposited on the surface of the film formation target 1 is realized. Note that, in the CVD process, it is not always necessary to repeatedly execute one cycle composed of the first to fourth steps. If the CVD film 4 with a necessary film thickness is obtained by the first to fourth steps, it is not necessary to execute two or more cycles.

As described above, the ALD process and the CVD process are commonized as the ALD cycle is executed in both the processes, and therefore it is possible to simplify the control of two different processes. In particular, since the CVD process is set in the same manner as the ALD cycle, except that the time T2_{c} of the second step is set to be shorter than the time T2_{A} of the second step of the ALD cycle, the control of two different processes can be extremely simplified.

In the CVD process of the embodiment, the supply of the source gas in the first step and the supply of the activated reactant gas in the third step are not performed simultaneously, and are separated by the second step. In the CVD process of the embodiment, the pressure of the source gas in the first step can be set to a relatively low pressure of, for example, 1 to 10 Pa like the first step of the ALD cycle. In the CVD process of the embodiment, the exhaustion in the second step is finished while leaving the source gas in the gas phase in the reaction container 20. These three points are completely different from conventional CVD processes. As the reason why the CVD process is executed in such a manner, the following three reasons will be given.

First, since the source gas remains in the gas phase in the reaction container 20 even after the exhaustion in the second step, the activated reactant gas introduced into the reaction container 20 in the third step reacts with the source gas in the gas phase, thereby realizing the chemical vapor deposition (CVD) process instead of the ALD process.

Another reason is to prevent a reverse flow of the source gas whose pressure becomes lower than the pressure of introducing the reactant gas by the exhaustion in the second step to the second supply pipe 200 and the reactant gas activation device 210, without excessively increasing the pressure of introducing the activated reactant gas in the third step. When a reverse flow of the source gas to the second supply pipe 200 and the reactant gas activation device 210 occurs, the source gas reacts with the reactant gas there, and the second supply pipe 200 and the reactant gas activation device 210 are contaminated with particles and by-products. In the embodiment, such contamination can be prevented. The pressure of introducing the activated reactant gas is a pressure that enables production of a plasma of the reactant gas in the reactant gas activation device 210, and is, for example, 5 to 15 Pa. When a first pressure P1 in the reaction container 20 after the second step is lower than a pressure P2 of introducing the activated reactant gas, it is possible to prevent the reverse flow described above, and thus the second step is necessary. Note that, since the valve 230 is closed after introducing the activated reactant gas, the source gas and the reactant gas do not react with each other in the second supply pipe 200 in the third step.

The other reason is that, unlike the reaction at a high pressure as in Patent Document 1, a decrease in the pressure of the r source gas by the exhaustion in the second step makes it harder to produce particles and by-products in the reaction container 20.

Note that, if a nitriding gas is used, for example, instead of an oxidation gas that is a reactant gas used when forming a metal oxide film, it is possible to form a metal nitride film. In this case, for the nitriding gas as the reactant gas, it is possible to use, for example, NH₃ from which NH radicals are produced. If TDMAS (SiH[N(CH₃)₂]₃) is used as the source gas, for example, it is possible to form a film of SiN, and, if TDMAT (Ti[N(CH₃)₂]₄) is used as the source gas, for example, it is possible to form a film of TiN. In both the cases, the presence of NH radicals can realize a low-temperature process.

### REFERENCE SIGNS LIST

- 1: film formation target
- 1A: hole
- 2: water
- 3: plasma
- 10: film formation device
- 20: reaction container
- 30: source gas introduction port
- 40: reactant gas introduction port
- 50: exhaust port
- 60: support
- 100: first supply pipe
- 110: source gas container
- 120: first valve
- 130: mass flow controller
- 200: second supply pipe
- 210: reactant gas activation device
- 212: high frequency power supply
- 220: reactant gas container
- 230: second valve
- 270: induction coil
- 300: exhaust pipe
- 310: exhaust pump
- 320: exhaust valve

## Claims

1. A film formation method for forming a CVD film and an ALD film on a film formation target, the film formation method comprising an ALD process for forming the ALD film, and a CVD process for forming the CVD film, wherein,
in the ALD process, an ALD cycle is repeatedly executed a plurality of times, the ALD cycle including:
a first step for filling a reaction container in which the film formation target is disposed, with a source gas introduced through a first supply pipe;
a second step for exhausting the source gas in a gas phase in the reaction container after the first step;
a third step for filling the reaction container with a reactant gas activated by an inductively coupled plasma in a second supply pipe and introduced through the second supply pipe after the second step; and
a fourth step for exhausting the reactant gas from the reaction container after the third step, and,
in the CVD process, the ALD cycle is executed at least once, and exhaustion in the second step is finished while leaving the source gas in the gas phase in the reaction container.

2. The film formation method according to claim 1, wherein
a time of the first step is substantially equally set in the ALD process and the CVD process, and
a time of the second step in the CVD process is set shorter than a time of the second step in the ALD process.

3. The film formation method according to claim 1 or 2, wherein
the source gas is an organometallic gas, and
the reactant gas is an oxidation gas.

4. The film formation method according to claim 1 or 2, wherein
the source gas is an organometallic gas, and
the reactant gas is a nitriding gas.

5. The film formation method according to any one of claims 1 to 4, wherein
the film deposition target is a porous material, and has a hole that opens at a surface on which a film is to be formed, and
the hole is closed with the CVD film by executing the CVD process, and then the ALD film is formed on the CVD film by executing the ALD process.

6. A film formation device comprising:
a reaction container in which a film formation target is disposed;
a first supply pipe that supplies a source gas to the reaction container;
a second supply pipe that is connected to the reaction container, and supplied with a reactant gas;
a reactant gas activation device that activates the reactant gas in the second supply pipe by an inductively coupled plasma;
an exhaust part that exhausts gas in the reaction container; and
a controller that controls a CVD process and an ALD process, wherein
the controller, in the ALD process, controls an ALD cycle to be repeatedly executed a plurality of times, the ALD cycle including:
a first step for introducing the source gas through the first supply pipe into the reaction container in which the film formation target is disposed;
a second step for exhausting the source gas from the reaction container through the exhaust part after the first step;
a third step for introducing the reactant gas activated in the second supply pipe by the reactant gas activation device into the reaction container through the second supply pipe after the second step; and
a fourth step for exhausting the reactant gas from the reaction container after the third step, and,
in the CVD process, controls the ALD cycle to be executed at least once, and the second step to be finished while leaving the source gas in a gas phase in the reaction container.
